Europäisches Patentamt

European Patent Office

Office européen des brevets

(11) Publication number: **0 242 876 B1**

(12) **EUROPEAN PATENT SPECIFICATION**

(45) Date of publication of patent specification: **12.08.92**  (51) Int. Cl.5: **H01R 43/20**, H05K 13/00

(21) Application number: **87105922.6**

(22) Date of filing: **23.04.87**

(54) **Method of indentifying cavity locations of electrical connector and indication device for the same.**

(30) Priority: **25.04.86 JP 97548/86**

(43) Date of publication of application:
**28.10.87 Bulletin  87/44**

(45) Publication of the grant of the patent:
**12.08.92 Bulletin  92/33**

(84) Designated Contracting States:
**DE ES FR GB**

(56) References cited:
**DE-A- 2 025 357**
**US-A- 4 462 155**

(73) Proprietor: **Sumitomo Wiring Systems, Ltd.
510, 1-14, Nishisuehiro-cho
Yokkaichi-City Mie Pref.(JP)**

(72) Inventor: **Yamada, Takeshi
1-14, Nishisuehiro-Cho Yokkaichi-City
Mie Pref.(JP)**
Inventor: **Ueda, Naoyuki
1-14, Nishisuehiro-Cho Yokkaichi-City
Mie Pref.(JP)**
Inventor: **Yamamoto, Kenzo
1-14, Nishisuehiro-Cho Yokkaichi-City
Mie Pref.(JP)**
Inventor: **Sano, Kenji
1-14, Nishisuehiro-Cho Yokkaichi-City
Mie Pref.(JP)**

(74) Representative: **KUHNEN, WACKER & PART-
NER
Alois-Steinecker-Strasse 22 Postfach 1553
W-8050 Freising(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to an improved device and method of identifying a cavity in a housing of an electrical connector into which a terminal attached to an electric wire shall be inserted.

The method of, and the device for identifying and indicating the specific cavity in a connector housing of the present invention is particularly useful when a plurarity of wires share a single connector housing with equivalent number of cavities to the number of wires, and when the wire terminal is connected with the mating connector terminal by manually inserting the wire with terminal into the corresponding cavity of the connector housing.

Up to now, in order to connect the terminal placed in one end of the lead wire with the connector housing, an operator puts the terminal into the cavity in a way that when he watches the cavity in a direction of the terminal's insertion, the cavity is allotted a number beginning from the left end to the right end in the first row and is given a number from the left end to the right end in the second row and those numbers and colours of the insulation coating of the lead wire are correlated. In the ahove mentioned connecting method it is diffcult for an operator, especially for a beginner, to put the terminal into the correct cavity according to instructions of those indices of colour and number. Particularly when the assembling wire is little in quantity and large in species, it is difficult for him to put the terminal into the right cavity in the housing because soon after he has become familiar with how to put the terminal into the corresponding cavity, he must learn another rule for putting the terminal into the cavity from the beginning.

DE-A-20 25 357 shows a method and an apparatus for identifying locations of electrical components with respect to a housing or the like. There is provided a kind of tool, by means of said tool one of a plurality of wires must be gripped in order to have a closed circuit such that one of a plurality of light emitting elements emits light into a corresponding lightwave guide which in turn indicates the correct position the wire must be inserted. So, it is necessary for an operator to positively grip one of the lead wires with the tool, because otherwise there is no closed electrical loop between tool, lead wire and the respective light emitting element lying in series therewith.

So, it is an object of the present invention to provide a method of identifying cavity locations of an electrical connector and an indication device for the same making it possible to positively identify the cavity in which a terminal has to be inserted without the necessity of tools or the like.

Solution of this object is achieved by what is claimed in claim 1 or 2.

According to the present invention, it is only necessary to grip one of the respective terminals to be inserted in a connector cavity by hand and by means of a simple touch or grip of the respective terminal by the operator's hand the connector cavity associated to said terminal is illuminated. Accordingly, detection of the correct cavity and a subsequent easy insertion of the terminal into the connector cavity is possible without the necessity of additional tools or the like.

According to the method of the present invention, the specific cavity in the second connector in a harness, to which the cavity of the first connector in the same harness corresponds, is identically indicated by illuminating the cavity with a light emitting diode equipped in a cavity of the mating connector.The LED emits light beams when a wiring operator touches a terminal which should be inserted for connection into the cavity in the second connector in a harness. The indication device for identifying the corresponding cavity is composed of connector housings with cavities, touch sensor means located inbetween the housings, a LED and a light wave guide. The touch sensor works when it catches the low pitched composite tone (hum) at the receiver output caused by fluctuations in the power supply induced by the human body.

The following is a more detailed description of the present invention taken in conjunction with the accompanying drawings in which:

Fig. 1
is a schematic diagram showing the method of identifying cavities in a housing of an electrical connector of the present invention;

Fig. 2
illustrates an electrical circuit for indication of a specific cavity in a housing of an electrical connector used in the present invention; and

Figs. 3(A) to 3(F)
illustrate the process for assemblying a plurality of electric wire leads according to the method of the present invention.

In the following description as well as in the claims, a single reference numeral always denotes a plurality of identical components or elements. This is furthermore emphazised by listing the sub-numerals having indices from "a" to "n" upon the first appearance of each reference numeral in the following description.

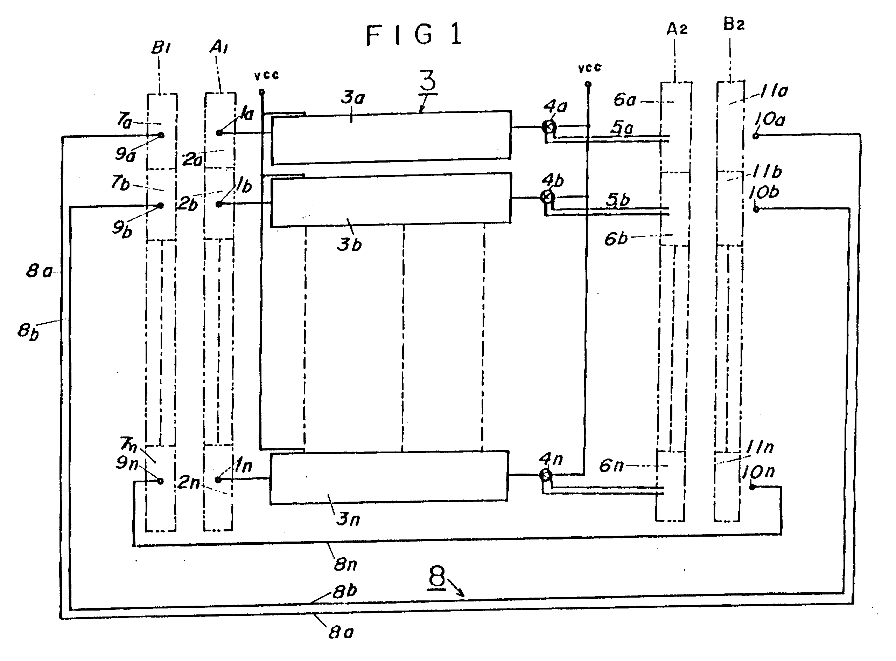

According to Figs 1 to 3(A), electrical terminals 9 [9a, 9b,...9n] and 10 [10a, 10b,...10n] are connected at the respective ends of lead wires 8 [8a, 8b,.. .8n]. The terminals 9 are inserted into cavities 7 [7a, 7b,...7n] in a connector housing B1.

Referring to Fig. 1, the method of identifying cavity locations in a housing of electrical connector is described. In the figure a circuit in the middle is the identification circuit of the present invention including two connectors A1 and A2 both having a plurality of open cavities 2 [2a, 2b,...2n) and 6 [6a, 6b,...6n], respectively. Between the two connectors A1 and A2 there are located a power source, touch sensor means 3 [3a, 3b,...3n], light emitting diodes 4 [4a, 4b,...4n] whose emitted light beams are transmitted by optical fibers 5 [5a, 5b,...5n] into the cavities 6 of the second connector A2. The first connector A1 in practice is placed in an engagement with the connector B1. Electrically connected with the second connector A2 there is a connector B2 without wire lead. The touch sensor means 3 is designed in a way that it detects the hum in the power source of the indication circuit and the light emitting elements 4 such as a light emitting diode (LED) emit a light beam when an operator in the practice touches any of the terminals 10 attached to the open ends of wire leads 8. The emitted light beam is introduced into the corresponding open cavity 6 in the second connector housing A2 through which the light beam can be visually recognized in the frame of the facing cavity 11 in the mated connector B2 and thus the location of the desired cavity 11 which corresponds thereto and thus an accurate connecting is made by merely inserting the electrical terminal 10 into the indicated cavity 11 in eletrical connector B2.

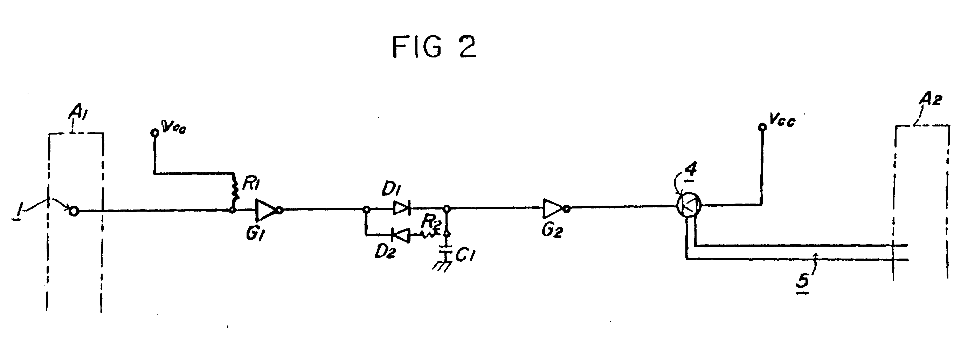

Fig. 2 shows a circuit diagram of the touch sensor means. When an operator touches sensing electrode 1 [1a, 1b,...1n] in the sensor means 3, a human body which works as an antenna causes a hum in the power source and the signal is inverted and amplified by an amplifying means such as a complementary metal oxide semiconductor (CMOS) G1 and is rectifyed by a circuit including diodes D1 and D2, a resistor R2 and a condenser C1. When the signal level exceeds a threshold votage level, an output level of the CMOS becomes lowered and light emitting element 4 such as a LED emits a light beam. On the contrary the light emitting element does not work when an operator does not touch the sensor means 3 at sensor electrode 1 since a high level of voltage is incurred to the input of CMOS G1 and both the output level of the CMOS G1 and an input level of CMOS G2 are equally lowered resulting in a high level of the latter CMOS G2.

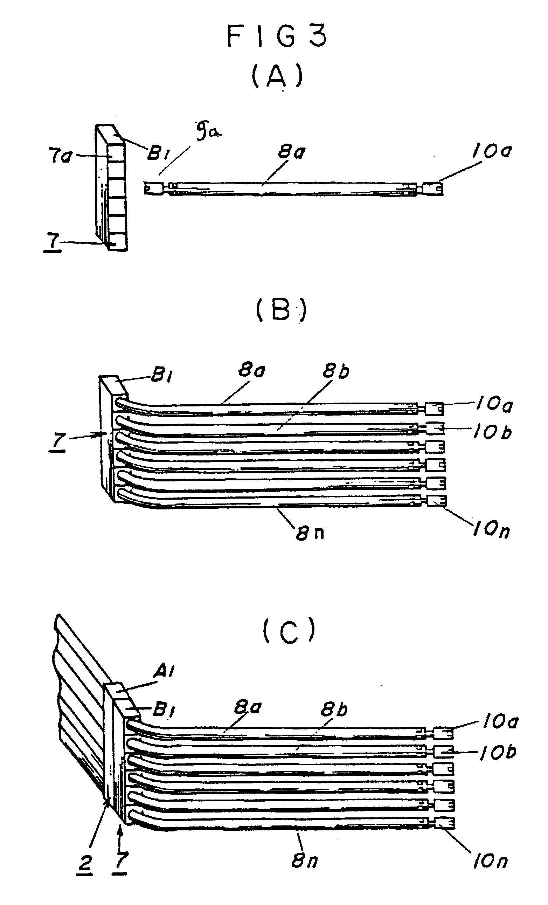

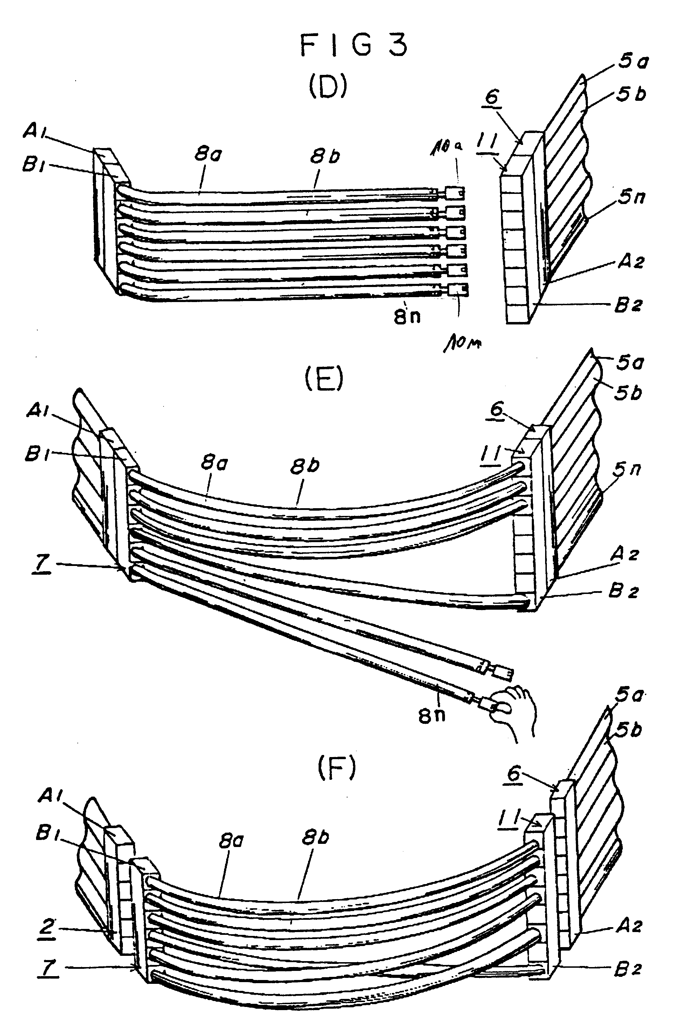

Referring now to Figs. 3(A) to 3(F), terminals 9 at one end of lead wires 8 are inserted into cavities 7 of the connector housing B1 in an order as shown in Fig. 3(A) and (B). When all circuits including lead wires 8 are of the same electric potential and when each lead wire 8 has the same electrical capacity, any one among terminals 9 may be arbitrarily inserted into one of the cavities 7 of the connector housing B1. The connector housing B1 is engaged with the connector housing A1 and terminals 9 are thus connected with the other end of the lead wires 8 function as the sensor electrode (as shown in Fig 3 (C)). When the above mentioned process is carried out, the connector housing B2 is engaged with the connector housing A2 and a cavity 11 [11a, 11b,...11n] of the connector housing B2 is connected with cavitiy 6 of connector housing A2 respectively (as shown in Fig. 3 (D)).

When the operator selects and holds terminals 10 which are provided at the other end of the plurality of lead wires 8 and touch sensor means 3 work, light emitting elements 4 located in cavities 6 of the connector housing A2 will indicate one of the cavities 11 of the connector housing B2 connected with cavities 6. By watching illuminated cavity 11, the operator puts terminals 10 into the corresponding cavity 11 (as shown in Fig. 3(E)). When the above mentioned work is completed, connector housings B1 and B2 are taken off connector housings A1 and B1. The assembly of electric wires which includes connector housings at both ends is completed (as shown in Fig. 3 (F)).

When any modification of the electrical circuit design must be made, mere shifting of the light transmittion guide(s) 5 to the newly destined cavity location(s) is sufficient for assembly practices.

Finally, the following is a list of reference numerals used in the foregoing description and the accompanying claims:

1 [1a, 1b,...1n]
sensor contact point
2 [2a, 2b,...2n]
cavity
3 [3a, 3b,...3n]
touch sensor means
4 [4a, 4b,...4n]
light emitting element
5 [5a, 5b,...5n]
light wave guide
6 [6a, 6b,...6n]
cavity
7 [7a, 7b,...7n]
cavity
8 [8a, 8b,...8n]
lead wire
9 [9a, 9b,...9n]
terminal
10 [10a, 10b,...10n]
terminal
11 [11a, 11b,...11n]
cavity
A1, A2, B1 and B2
connector housing

## Claims

1. A device for indicating a cavity location in the housing of an electrical connector (B2) and intended for use in making connections between two electrical connectors (B1, B2), comprising the following elements:

a first connector housing (A1) with cavities (2), electrically connected with a sensor means (3) and being capable to be mated with one (B1) of said electrical connectors (B1, B2), which is itself connected to the wires (8) of a cable;

a light emitting element (4) connected to said sensor means (3) which emits a light beam or not, depending on the level of the output of said sensor means;

a light wave guide (5) for transmitting the light beam being emitted by said light emitting element (4); and

a second connector housing (A2) with open cavities (6), which receive an end portion of said light wave guide (5) and are free from obstacles for passage of a light beam, said second connector housing (A2) being capable to be mated with the other electrical connector (B2) before said other electrical connector (B2) receives the other end of said wires (8) of said cable,

characterized in that

said sensor means (3) is comprised of a touch sensor means being sensitive for the touch of a human person for detecting a hum in a power source of said device, said touch sensor means consisting substantially of switching elements (G1, G2), a power supply, resistors (R1, R2), an amplifier rectifyer (R2, D1, D2), a condenser (C1) and input/output-terminals (1, Vcc).

2. A method of making a connection between two electrical connectors (B1, B2) with wire leads (8) including the steps of:

- connecting each terminal (9) attached to one end portion of each wire lead (8) with a mating connector terminal in a cavity (7) of one (B1) of the electrical connectors (B1, B2), thereby leaving the other end portion (10) of each wire lead (8) unconnected;

- connecting a touch sensor means (3) which is capable of detecting a hum at an electric power source with the connector terminal in each of the cavities (7) of said first electrical connector (B1) and with a light emitting element (4) with a light wave guide (5) for transmission of a light beam upon occurence of detection of a hum, said touch sensor means consisting essentially of switching elements (G1, G2), a power supply, resistors (R1, R2), an amplifier rectifyer (R2, D1, D2), a condenser (C1) and input/output-terminals (1, Vcc);

- introducing the end portion of the light wave guide (5) into an open cavity of an electrical connector (A2) to be mated with said second electrical connector (B2) having no obstacle for passage of the light beam; and

- allowing illumination of a specific cavity (11) in the second electrical connector (B2) through the facing cavity (6) in said electrical connector (A2) by light beams, by touching one of the open ends (10) of the wire leads (8), and thus indicating location of the corresponding cavity (11) into which the terminal (10) on the wire lead (8) is to be be inserted and connected.

**Revendications**

1. Dispositif pour indiquer un emplacement de cavité dans le logement d'un connecteur électrique (B2) et destiné à être utilisé pour établir les connexions entre deux connecteurs électriques (B1, B2) comprenant les éléments suivants :

un premier logement de connecteur (A1) comprenant des cavités (2), connecté électriquement à un moyen de détection (3) et pouvant être raccordé à un (B1) des connecteurs électriques (B1, B2) qui est lui-même connecté aux fils (8) d'un câble ;

un élément émettant de la lumière (4)- connecté audit moyen de détection (3) qui émet un faisceau lumineux ou ne l'émet pas, fonction du niveau de sortie du moyen de détection ;

un guide d'onde de lumière (5) pour transmettre le faisceau lumineux étant émis par ledit élément émettant de la lumière (4) ; et un second logement de connecteur (A2) avec des cavités ouvertes (6) qui reçoivent une partie d'extrémité du guide d'onde lumineux (5) et sont prévus pour laisser passer un faisceau lumineux, ledit second logement de connecteur (A2) pouvant être raccordé à l'autre connecteur électrique (B2) avant que ledit autre connecteur électrique (B2) reçoive l'autre extrémité desdits fils (8) dudit câble,

caractérisé en ce que

ledit moyen de détection (3) est constitué d'un moyen de détection de toucher qui est sensible au toucher d'une personne humaine pour détecter un ronflement dans une source d'alimentation dudit dispositif, ledit moyen de détection de toucher étant constitué principalement d'éléments de commutation (G1, G2), d'une alimentation, de résistances (R1, R2), d'un redresseur amplificateur (R2, D1, D2), d'un condensateur (C1) et de bornes d'entrée/sortie (1, Vcc).

2. Procédé pour établir une connexion entre deux connecteurs électriques (B1, B2) avec des conducteurs d'un câble (8) comportant les étapes consistant à :

- connecter chaque borne (9) reliée à une partie d'extrémité de chaque conducteur du câble (8) avec une borne de connecteur de raccordement dans une cavité (7) d'un (B1) des connecteurs électriques (B1, B2), laissant de ce fait l'autre partie d'extrémité (10) de chaque conducteur du câble (8) non connectée ;

- connecter un moyen de détection de toucher (3) qui peut détecter un ronflement dans une source d'alimentation électrique avec la borne de connecteur dans chacune des cavités (7) dudit premier connecteur électrique (B1) et avec un élément émettant de la lumière (4) comportant un guide d'onde lumineux (5) pour transmission d'un faisceau lumineux sur présence de la détection d'un ronflement, ledit moyen de détection de toucher étant constitué principalement d'éléments de commutation (G1, G2), d'une alimentation, des résistances (R1, R2), d'un redresseur amplificateur (R2, D1, D2), d'un condensateur (C1) et des bornes d'entrée/sortie (1, Vcc) ;

- introduire la partie d'extrémité du guide d'onde lumineux (5) dans une cavité ouverte d'un connecteur électrique (A2) qui doit être raccordé audit second connecteur électrique (B2) n'empêchant pas le passage du faisceau lumineux, et

- permettre l'éclairement d'une cavité spécifique (11) dans le second connecteur électrique (B2) à travers la cavité lui faisant face (6) dans le connecteur électrique (A2) par les faisceaux lumineux en touchant une des extrémités ouvertes (10) des conducteurs du câble (8) et en indiquant ainsi l'emplacement de la cavité correspondante (11) dans laquelle la borne (10) sur le conducteur du câble (8) doit être insérée et connectée.

**Patentansprüche**

1. Eine Vorrichtung zum Anzeigen einer Kammeranordnung in dem Gehäuse eines elektrischen Verbinders (B2), vorgesehen zur Verwendung bei der Herstellung von Verbindungen zwischen zwei elektrischen Verbindern (B1, B2), mit den folgenden Elementen:
einem ersten Verbindergehäuse (A1) mit Kammern (2), elektrisch in Verbindung mit einer Sensoreinrichtung (3) und in der Lage, mit einem (B1) der elektrischen Verbinder (B1, B2) zusammenzupassen, der seinerseits mit den Litzen (8) eines Kabels verbunden ist;
einem lichtemittierenden Element (4), welches mit der Sensoreinrichtung (3) verbunden ist und einen Lichtstrahl oder nicht abgibt, abhängig von dem Pegel des Ausganges der Sensoreinrichtung;
einem Lichtwellenleiter (5) zum Übertragen des von dem lichtemittierenden Element (4) emittierten Lichtstrahles; und
einem zweiten Verbindergehäuse (A2) mit offenen Kammern (6), welche einen Endabschnitt des Lichtwellenleiters (5) aufnehmen und hindernisfrei sind zum Durchlaß eines Lichtstrahles, wobei das zweite Verbindergehäuse (A2) in der Lage ist, mit dem anderen elektrischen Verbinder (B2) zusammengefügt zu werden, bevor der andere elektrische Verbinder (B2) das andere Ende der Litzen (8) des Kabels aufnimmt,

dadurch gekennzeichnet, daß

die Sensoreinrichtung (3) aus einer Berührungssensor-Einrichtung besteht, welche auf die Berührung durch eine menschliche Person anspricht, um einen Brumm in einer Energiequelle der Vorrichtung zu detektieren, wobei die Berührungssensor-Einrichtung im wesentlichen aus Schaltelementen (G1, G2), einer Energieversorgung, Widerständen (R1, R2), einem Verstärkergleichrichter (R2, D1, D2), einem Kondensator (C1) und Eingangs/Ausgangs-Anschlüssen (1, Vcc) besteht.

2. Ein Verfahren zur Herstellung einer Verbindung zwischen zwei elektrischen Verbindern (B1, B2) mit Drahtlitzen (8), mit den folgenden Schritten:

- Verbinden eines jeden Anschlusses (9), der an einem Endabschnitt einer jeden Drahtlitze (8) angeordnet ist mit einem passenden Verbinderanschluß in einer Kammer (7) von einem (B1) der elektrischen Verbinder (B1, B2), wobei der andere Endabschnitt (10) einer jeden Drahtlitze (8) unangeschlossen verbleibt;

- Verbinden einer Berührungssensor-Einrichtung (3), welche in der Lage ist, einen Brumm in einer elektrischen Energiequelle zu detektieren mit dem Verbinderanschluß in jeder der Kammern (7) des ersten elektrischen Verbinders (B1) und mit einem Lichtemittierenden Element (4) mit einem Lichtwellenleiter (5) zur Übertragung eines Lichtstrahles beim Auftreten des Erkennens eines Brumms, wobei die Berührungssensor-Einrichtung im wesentlichen aus Schaltelementen (G1, G2), einer Energieversorgung, Widerständen (R1, R2), einem Verstärkergleichrichter (R2, D1, D2), einem Kondensator (C1) und Eingangs/Ausgangs-Anschlüssen (1, Vcc) besteht;

- Einbringen des Endabschnittes des Lichtwellenleiters (5) in eine offene Kammer eines elektrischen Verbinders (A2), der dem zweiten elektrischen Verbinder (B2), der keine Hindernisse für den Durchlaß des Lichtstrahles aufweist, angepaßt ist; und

- Ermöglichen einer Beleuchtung einer speziellen Kammer (11) in dem zweiten elektrischen Verbinder (B2) durch die gegenüberliegende Kammer (6) in dem elektrischen Verbinder (A2) durch Lichtstrahlen, indem eines der offenen Enden (10) der Drahtlitzen (8) berührt wird und somit die Anordnung der entsprechenden Kammer (11) angezeigt wird, in welche der Anschluß (10) der Drahtlitze (8) einzuführen und anzuschließen ist.

FIG 1

FIG 2

# FIG 3

## (A)

## (B)

## (C)

# F I G 3

## (D)

## (E)

## (F)